(19) Europäisches Patentamt
European Patent Office
Office européen des brevets

(11) **EP 1 238 405 B1**

(12) **EUROPEAN PATENT SPECIFICATION**

(45) Date of publication and mention
of the grant of the patent:
**18.06.2014 Bulletin 2014/25**

(51) Int Cl.:
*H01J 37/28* (2006.01)          *H01J 37/147* (2006.01)
*H01J 37/153* (2006.01)          *G01B 15/04* (2006.01)

(21) Application number: **99964573.2**

(22) Date of filing: **14.12.1999**

(86) International application number:
**PCT/EP1999/009926**

(87) International publication number:
**WO 2001/045136 (21.06.2001 Gazette 2001/25)**

(54) **METHOD AND SYSTEM FOR THE EXAMINATION OF SPECIMEN USING A CHARGED PARTICLE BEAM**

VERFAHREN UND SYSTEM ZUR UNTERSUCHUNG VON SUBSTRATOBERFLÄCHEN MITTELS TEILCHENSTRAHLAPPARAT

PROCEDE ET SYSTEME D'EXAMEN D'UN ECHANTILLON AVEC UN FAISCEAU DE PARTICULES CHARGEES

(84) Designated Contracting States:
**AT BE CH CY DE DK ES FI FR GB GR IE IT LI LU MC NL PT SE**

(43) Date of publication of application:
**11.09.2002 Bulletin 2002/37**

(73) Proprietor: **Applied Materials, Inc.**
**Santa Clara, CA 95054 (US)**

(72) Inventors:
• **GOLDENSHTEIN, Alex**
**75239 Rishon LeZion (IL)**
• **BEN-AV, Radel**
**Rehovot (IL)**
• **PEARL, Asher**
**45297 Hod Hsharon (IL)**
• **PETROV, Igor**
**58483 Holon (IL)**
• **HAAS, Nadav**
**79411 Merkaz-Shapira (IL)**
• **ADAMEC, Pavel**
**D-85540 Haar (DE)**

(74) Representative: **Zimmermann & Partner**
**Postfach 330 920**
**80069 München (DE)**

(56) References cited:
EP-A- 0 312 083          EP-A- 0 345 772
EP-A- 1 045 426          WO-A-99/34397
DD-A- 126 382            GB-A- 1 359 063

GB-A- 2 067 348          JP-B- 49 022 768
US-A- 3 930 181          US-A- 4 221 965
US-A- 4 376 249          US-A- 4 725 730
US-A- 4 785 176          US-A- 4 926 054
US-A- 4 983 832          US-A- 5 644 132

• "LOCAL HIGH MAG SCANNING AT TWO TAIL ENDS OF LOW MAG SCANNING FOR CREATING HIGH MAG SEM STEREO IMAGES" IBM TECHNICAL DISCLOSURE BULLETIN,US,IBM CORP. NEW YORK, vol. 34, no. 4B, 1 September 1991 (1991-09-01), pages 271-273, XP000189491 ISSN: 0018-8689
• WATT I. M.: "The principles and practice of electron microscopy" 1985 , CAMBRIDGE UNIVERSITY PRESS , CAMBRIDGE XP002147128 page 142, left-hand column, line 5 -page 144, right-hand column, line 10; figure 4.17
• PATENT ABSTRACTS OF JAPAN vol. 1999, no. 02, 26 February 1999 (1999-02-26) & JP 10 302703 A (HITACHI LTD;HITACHI INSTR ENG CO LTD), 13 November 1998 (1998-11-13)
• PATENT ABSTRACTS OF JAPAN vol. 007, no. 251 (E-209), 8 November 1983 (1983-11-08) & JP 58 137949 A (NIPPON DENSHI KK), 16 August 1983 (1983-08-16)
• "SIMULTANEOUS SHIFT AND SCAN IN AN SEM USING SCAN COILS" IBM TECHNICAL DISCLOSURE BULLETIN,US,IBM CORP. NEW YORK, vol. 33, no. 1A, 1 June 1990 (1990-06-01), pages 112-113, XP000120021 ISSN: 0018-8689

- PATENT ABSTRACTS OF JAPAN vol. 003, no. 129 (E-147), 26 October 1979 (1979-10-26) & JP 54 107254 A (HITACHI LTD), 22 August 1979 (1979-08-22)
- FINNES S. J. AND SMITH G. J.: "Nondestructive Slope/Thickness Measurement for Semiconductor Topology" IBM TECHNICAL DISCLOSURE BULLETIN, vol. 26, no. 1, 1 June 1983 (1983-06-01), pages 189-190, XP002153556 New York, US
- KEIJI NAKAJIMA ET AL: "DEVELOPMENT OF A 3-D MEASURING SYSTEM FOR SEMICONDUCTOR PATTERNED WAFERS" PROCEEDINGS OF THE ANNUAL CONFERENCE OF THE INDUSTRIAL ELECTRONICS SOCIETY. (IECON),US,NEW YORK, IEEE, vol. CONF. 16, 27 November 1990 (1990-11-27), pages 497-500, XP000217280 ISBN: 0-87942-600-4
- MIZUNO F ET AL: "OBSERVATION OF DEEP HOLES USING THE BEASTLI (BACKSCATTERED ELECTRONS ASSISTING LSI INSPECTION) METHOD" OPTICAL ENGINEERING,US,SOC. OF PHOTO-OPTICAL INSTRUMENTATION ENGINEERS. BELLINGHAM, vol. 33, no. 5, 1 May 1994 (1994-05-01), pages 1684-1691, XP000440842 ISSN: 0091-3286

## Description

FIELD OF THE INVENTION

The invention relates to a method and a system for the examination of specimen. Especially, the invention relates to a method and a system for the examination of specimen with a beam of charged particles.

BACKGROUND OF THE INVENTION

The resolution of the conventional optical microscopy is limited by the wavelength of the visible light. Furthermore, at the highest resolution the conventional optical microscopy has a very shallow depth of field. These two limitations have led to the increased popularity of charged particle devices for the examination of specimen. Compared to optical light accelerated charged particles, for example electrons, do exhibit a shorter wavelength, which leads to an increased resolution power. Accordingly, charged particle beams, especially electron beams, are used in a variety of ways in biology, medicine, the materials sciences, and lithography. Examples include the diagnosis of human, animal, and plant diseases, visualization of sub cellular components and structures such as DNA, determination of the structure of composite materials, thin films, and ceramics, or the inspection of masks and wafers used in semiconductor technology.

Furthermore, charged particle devices are well suited for the examination of the microstructure of solid surfaces. Especially, the scanning electron microscope is a versatile instrument for examining the microstructure of a surface, because it combines high spatial resolution with depth of field in the same image, and requires only minimal sample preparation. Modem instruments distinguish features as small as 1 nm, while retaining crisp focus throughout tens of microns in the vertical direction. Hence, it is well suited for routine inspections of the intricate surface details of highly integrated circuits. Charged particle devices may, for example, be used in order to monitor the quality of the wafer processing in the semiconductor industry. Thereby, the device is actually located within the production environment, so that problems of the wafer processing are recognized as soon as possible.

However, conventional charged particle devices are not capable of providing accurate critical dimension, accurate height or accurate edge width measurements without the need of massive manual interference. In order to measure, for example, the height difference between two image points, usually two images are recorded with a defined specimen tilt between the exposures. However, mechanically tilting the specimen leads to a number of disadvantages. Due to mechanical imperfections a lateral movement of the specimen is inevitable which often results in misregistrations between the elements of a stereo image pair. Accordingly, additional alignments are necessary which slow down the process considerably. Furthermore, tilting large specimen, for example a 12 inch semiconductor wafer, requires a very robust and costly mechanical configuration in order to guarantee an adequate resistance of such a stage against vibrations.

In order to overcome the problems connected with a mechanical tilt of the specimen, it has been proposed to tilt the electron beam electrically in the electron-optical column to procure the same result, see e.g. B.C. Brenton et al. "A DYNAMIC REAL TIME 3-D MEASUREMENT TECHNIQUE FOR IC INSPECTION", Microelectronic Engineering 5 (1986) 541 - 545, North Holland or J.T.L. Thong et al. "In Situ Topography Measurement in the SEM", SCANNING Vol. 14, 65 -72 (1992), FAMS, Inc.. However, the height resolution of the proposed systems lies in the range of 75 to 100 nm, which is not sufficient for the requirements of the semiconductor industry.

Due to these problems, critical dimension measurements and side wall profiling are often done with an atomic force microscope. However, using an atomic force microscope requires an additional experimental setup which increases the costs significantly and is also very slow. Accordingly, there is a need for a faster and more automated method of examing a specimen which allows accurate critical dimension, accurate height or accurate edge width measurements.

Methods of analysing a specimen with an electron beam, in which the beam is tilted and the specimen is moved to two positions corresponding to the tilt of the beam so that the beam hits the same region of the sample under two different angles, are known from JP-A-58/137949 and IBM Technical Disclosere Bulletin, "Local High Mag Scanning at Two Tail Ends of Low Mag Scanning For Creating High Mag Stereo Images", Vol. 34, No. 4B, 1991.

SUMMARY OF THE INVENTION

The present invention provides a method for the examination of specimen with a beam of charged particles according to claim 1. The present invention also provides an apparatus for the examination of specimen that is capable of performing this improved method according to claim 11. The method provides one or more images of the specimen made with different view angles, so that, compared to a single top view image of the specimen, a lot of additional information about the specimen can be accessed. The different view angles (angles of incidence) are achieved by tilting the beam between the two images and moving the specimen to a new position so that the displacement of the beam caused by the tilting of the beam is compensated. Accordingly, while displaying/recording the second image the beam scans basically over the same area as it has scanned while displaying/recording the first image.

By providing an oblique angle of incidence on the one hand and a corresponding movement of specimen on the other hand, stereo images of a specimen can be produced in a fast and reliable manner without the need for any additional alignments and without the need for excessive image processing. Accordingly, the additional information, which is contained in stereo images and which is extremely valuable in many cases, can be accessed without causing any additional costs.

The predetermined angle of incidence is achieved by the combined action of deflecting the beam away from the optical axis of an objective and focusing the beam onto the specimen. The deflection is done in at least two steps which are adjusted to each other so that the chromatic aberrations on the surface of the specimen are minimized.

It has been found by the present inventors that the chromatic aberrations caused by the first step of the deflection can be compensated to a large extent by the second step of the deflection if the two deflections are properly adjusted. The combined action of the two step deflection and focussing of the beam then leads to a resolution in the range of a few nanometers, which is comparable with the resolution that can be achieved without providing an oblique angle of incidence. The invention has thus the advantage that large angles of incidence on a specimen can be provided without a reduction in resolution arising from large chromatic aberrations.

According to a still further aspect of the present invention, methods are provided that allow an accurate measurement of important distances on the surface of a specimen, especially on the surface on a semiconductor wafer. These methods use a tilted beam of charged particles to get the information in a very fast and reliable manner.

BRIEF DESCRIPTION OF THE DRAWINGS

Some of the above indicated and other more detailed aspects of the invention will be described in the following description and partially illustrated with reference to the figures. Therein:

Fig. 1 is a schematic diagram of a charged particle apparatus according to a first embodiment of the present invention.

Fig. 2 is a schematic diagram of a charged particle apparatus according to a second embodiment of the present invention.

Fig. 3 is a schematic diagram of a charged particle apparatus according to a third embodiment of the present invention..

Fig. 4 is an enlarged view showing the objective lens of the embodiment of Fig. 3.

Fig. 5 is an enlarged view of Fig. 4.

Fig. 6A and Fig. 6B show a pillar which extends from a flat surface and whose height is to be determined.

Fig. 7A and Fig. 7B show a contact hole which is extending downward from a flat surface and whose width at its bottom is to be determined.

Fig. 8A and Fig. 8B show a line which is extending upward from a flat surface and whose width at its bottom is to be determined.

Fig. 9A and Fig. 9B show a top view and a tilt view of a trench present on the surface of a wafer.

Fig. 10A and Fig. 10B show a top view and a tilt view of a line present on the surface of a wafer.

DESCRIPTION OF THE PREFERRED EMBODIMENTS

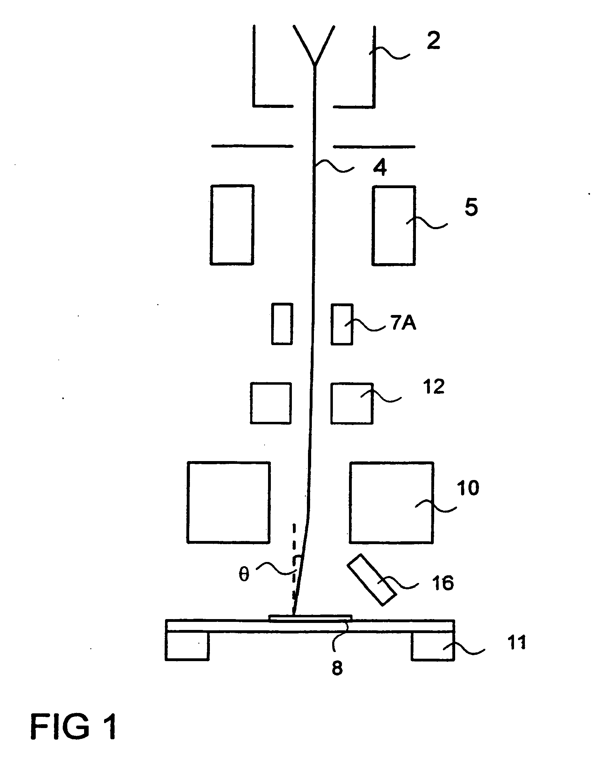

Preliminary, it should be appreciated by those skilled in the art that the present invention can be used with any charged particle device. However, for convenience, the invention will be described with respect to its implementation in a scanning electron microscope (SEM). A preferred embodiment according to the invention is shown schematically in Fig. 1. The basic components of the device are an electron source 2, a lens system (condenser lens 5 and objective lens 10), scanning coils 12A and 12B, beam shift coils 7 and a detector 16. In operation an electron beam 4 is emitted from the electron source 2. The electron source may, for example, be a tungsten-hairpin gun, a lanthanum-hexaboride gun, or a field-emission gun. The electrons are accelerated by an accelerating voltage supplied to the electron source 2. Since the beam diameter produced directly by the electron source usually is too large to generate a sharp image at high magnification, the electron beam 4 is guided through the condenser lens 5, which demagnifies the beam and leads the electron beam 4 towards a specimen 8.

The electron beam 4 then enters the field of the deflector 7A which deflects the electron beam 4 away from its path along the optical axis of the objective lens 10. The deflector 7A is followed by the scanning coils 12, which are used to move the electron beam 4 in a television-like raster over the surface of the specimen 8. After the scanning coils 12 the electron beam 4 enters the objective lens 10 that focuses the electron beam 4 onto the specimen 8. The objective lens 10 not only focuses the electron beam 4 but also rotates the electron beam 4. However, this effect is not shown, because it is difficult to depict in a two-dimensional drawing and because the skilled person is well aware of this additional effect.

Due to the combined action of the deflector 7A and the objective lens 10, the electron beam 4 hits the specimen under a predetermined angle of incidence, preferably in the range between 1° and 20° degrees. When the electrons strike the surface of the specimen 8, a variety of secondary products, such as electrons of different energy, X rays, light, and heat, as well as electrons scattered backward are produced. Many of these secondary products and/or the backscattered charged particles are used to produce the image of the specimen and to collect additional data from the specimen. A secondary product of major importance to examination or the image formation of specimens are secondary electrons that escape from the specimen 8 at a variety of angles with relatively low energy (3 to 50 eV). The secondary and the back scattered electrons reach the detector 16 and are measured. By scanning the electron beam over the specimen and displaying/recording the output of the detector 16 an image of the surface of the specimen 8 is formed.

The specimen 8 is supported on a stage 11 (specimen support) which is moveable horizontally in all directions, in order to allow the electron beam 4 to reach the target areas on the specimen which are to be examined. When the specimen 8 is viewed under an oblique angle of incidence, the electron beam does not hit the specimen along the optical axis but it is displaced from the optical axis. Therefore, the stage 11 performs a corresponding movement with the specimen 8 so that the electron beam hits the same area on the specimen that would have been hit if the electron beam had not been deflected by the beam shift coils 7A. When the deflection of the electron beam 4 and, accordingly, the angle of incidence is changed, for example to produce a pair of stereo images, the stage 11 again moves the specimen 8 to a new position so that the displacement of the beam caused by the tilting of the beam is compensated. Accordingly, any misregistration between the two images can basically be avoided.

By providing an oblique angle of incidence on the one hand and a corresponding movement of specimen on the other hand, stereo images of a specimen can be produced in a fast and reliable manner without the need for any additional alignments. Accordingly, the additional information, which is contained in stereo images and which is extremely helpful in many cases, can be accessed without causing any additional costs. Normally, both images of a stereo pair are produced using an oblique angle of incidence. However, depending on the application, one of the stereo images may also be produced by using a top view of the specimen ($\theta = 0°$).

The embodiment shown in Fig. 1 uses a pre-lens deflector 7A in order to deflect the electron beam 4. The deflection of the electron beam 4 leads to an off-axis path of the beam through the objective lens 10 which gives rise to chromatic aberrations.

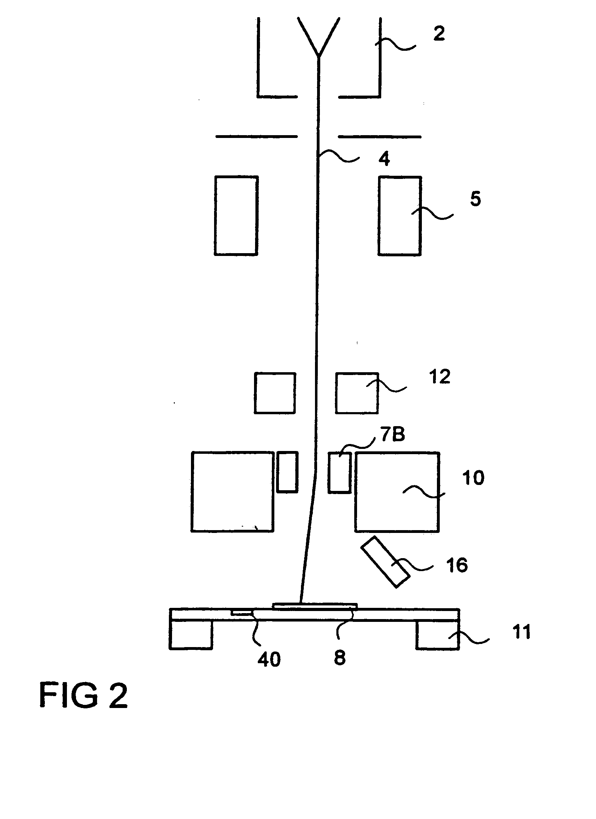

In order to decrease the chromatic aberrations, Fig. 2 shows a schematic diagram of an apparatus according to a further embodiment of the present invention. This embodiment is similar to that of Fig. 1, except for the following. The pre-lens deflector 7A has been replaced by an in-lens deflector 7B that is located within the objective lens 10. When the deflector 7B is placed inside the field of the objective lens 10, the chromatic aberrations are reduced considerably. The reduction can amount to 50% or more, if the deflector 7B is placed deep inside the field of the objective lens 10 or even partly below the objective lens 10.

In order to further improve the performance of system, the embodiment shown in Fig. 2 contains a reference target 40 integrated into the stage 11. The reference target 40 is used to determine the precise angle of incidence of the electron beam 4 hitting the reference target 40. For example, the reference target may contain a repeating structure of lines or trenches which exhibit vertical walls. By moving the stage 11 so that the reference target 40 comes within the scanning range of the electron beam 4, images of the reference target 40 can be used to measure the angle of incidence and to find a parameter setting (for example for the deflector 7B, the objective lens 10, the beam energy, etc.) so that electron beam 4 hits the reference target 40 with predetermined angle of incidence. Once this parameter setting has been found, it can be used for precise measurements on the actual specimen 8 later on.

In the embodiment shown in Fig. 2 the reference target 40 is integrated into the stage 11. However, the reference target 40 might as well be provided on a separate support, which for example can be rotated in order to bring the reference target 40 within the scanning range of the electron beam 4. Furthermore, a heating system (not shown) can be provided for the reference target 40 so that by heating the reference target 40 contaminants present on the surface of the target are evaporated. By heating the reference target from time to time a clean reference target can be guaranteed over long period of time. Accordingly, the down time of the complete system can be reduced.

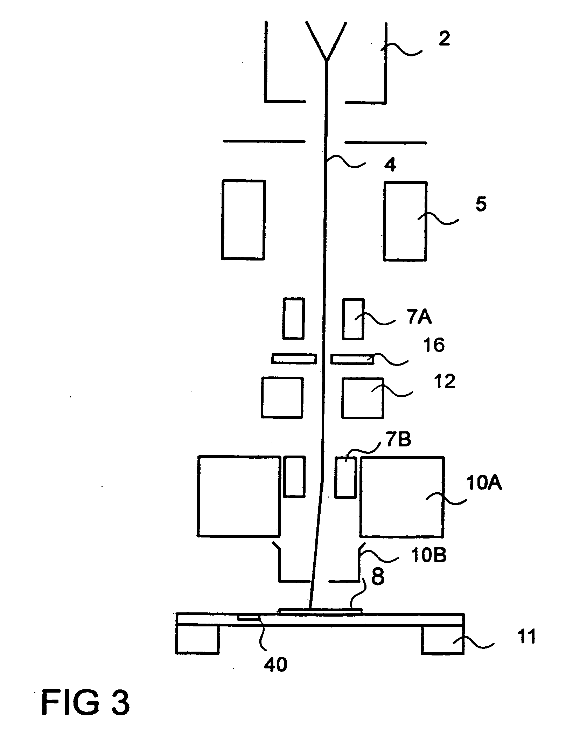

In order to further decrease the chromatic aberrations, Fig. 3 shows a schematic diagram of an apparatus according to a further embodiment of the present invention. This embodiment is similar to that of Fig. 1 and Fig. 2, except for the following. Instead of using either a pre-lens deflector 7A or an in-lens deflector 7B, the embodiment shown in Fig. 3 uses the pre-lens deflector 7A and the in-lens deflector 7B in combination. It has been found by the present inventors that the chromatic aberrations caused by a first deflector, in this example the pre-lens deflector 7A, can be compensated to a large extent by a second deflector, in this example the in-lens deflector 7B, if the deflections caused by these coils are properly adjusted. In the present example a pre-lens deflector 7A and an in-lens deflector 7B are used. However, it is also possible to use two pre-lens deflectors or two in-lens deflectors to achieve the same results.

The precise adjustment of the two deflections depends on a number of parameters, for example the chosen angle of incidence, the beam energy, the objective lens current, etc.. However, the practice of the invention does not depend on a precise knowledge of these parameters and their effects on the chromatic aberrations caused by the beam deflection. The direction of the deflection and the angle of deflection of the pre-lens and the in-lens deflector at which for a preselected angle of incidence minimum aberration is obtained may be extracted experimentally from the resulting images, either from the images of the specimen 8 itself or from images of the reference target 40. The combined action of the pre-lens deflector and the in-lens deflector then lead to a resolution in the range of a few nanometers, which is comparable with the resolution that can be achieved without providing an oblique angle of incidence. The invention has thus the advantage that large angles of incidence on a specimen can be provided without a reduction in resolution arising from large chromatic aberrations.

In order to further improve the performance of system, the embodiment shown in Fig. 3 contains an objective lens 10 which is a combination of a magnetic lens 10A and an electrostatic lens 10B. Accordingly, the objective lens 10 is a compound magnetic-electrostatic lens. Preferably, the electrostatic part of the compound magnetic-electrostatic lens 10 is an electrostatic retarding lens 10B. Using such a compound magnetic-electrostatic lens 10 yields superior resolution at low acceleration energies, such as a few hundred electron volts in case of a SEM. Such low acceleration energies are desirable, especially in modem semiconductor industry, to avoid charging and/or damaging of radiation sensitive specimens.

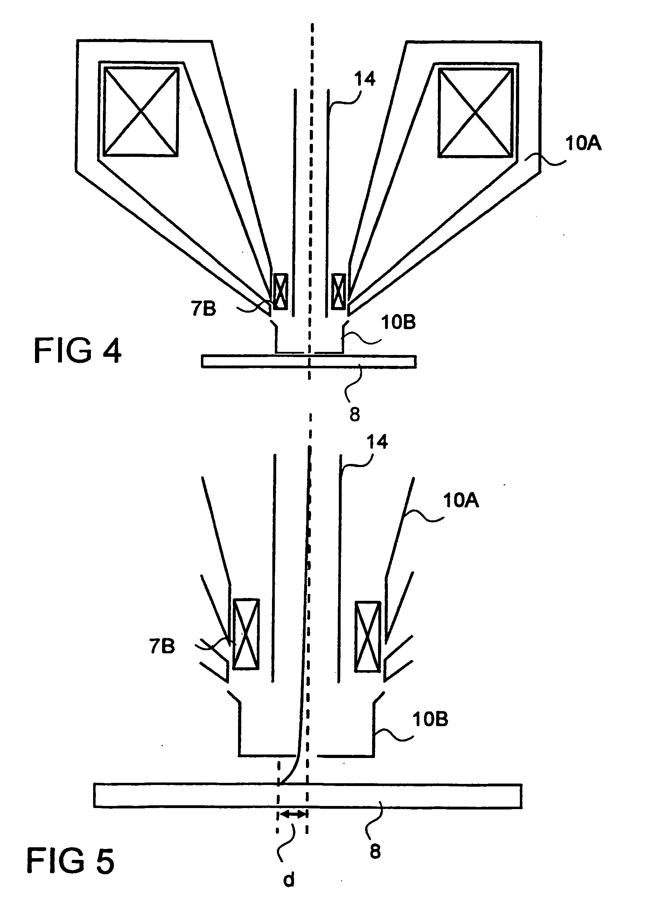

Figures 4 and 5 show enlarged views on the compound magnetic-electrostatic lens 10 and the specimen 8 as shown in Fig. 3. To achieve a small focal length, the magnetic flux generated by a current through an excitation coil is conducted through pole pieces and is concentrated into a small region along the optical axis of the magnetic lens. The magnetic field is rotational symmetric around the optical axis and reaches its maximum value in the pole gap between the upper and the lower pole piece. Furthermore, the beam shift coils 7B are placed inside the magnetic field of the objective lens 10A, so that there is considerable overlap between their respective fields.

In addition to the magnetic lens 10A the embodiment shown in Figs. 3 to 5 contains an electrostatic retarding lens which is situated close to magnetic lens 10A. The electrostatic retarding lens 10B has two electrodes held at different potentials. In the illustrated embodiment one of the two electrodes is formed by a cylindrical beam tube 14 which is arranged within the magnetic lens 10A along the optical axis. The second electrode of the electrostatic retarding lens 10B is a metallic cup provided below the magnetic lens 10A. In operation of the system the first electrode is usually held at high positive potential, for example 8 kV, where as the second electrode is held at lower positive potential, for example 3 kV, so that the electrons are decelerated in the corresponding electrostatic field from a first energy to lower second energy.

In the example shown in Figs 4 and 5 the specimen 8 is held at ground potential. Accordingly, there is a further electrostatic retarding field between the metallic cup and the specimen 8. Due to the electrostatic retarding field between the metallic cup and the specimen 8, an initial deflection of the electron beam 4 caused by the beam shift coils 7A and 7B is enhanced leading to an increased angle of incidence. Accordingly, in order to achieve a predetermined angle of incidence only small deflections caused by the beam shift coils 7A and 7B are necessary.

The surface of the specimen need not be grounded. The electric potential on the surface of the specimen may also be adjusted by applying a voltage to the specimen. A voltage can be applied to a wafer, for example, in order to obtain voltage contrast imaging which is used to detect shorts in a circuit. As long as the potential of the metallic cup is higher than the potential on the surface of the specimen, an electrostatic retarding field is produced.

As can be seen from Fig. 5, when the specimen 8 is viewed under an oblique angle of incidence $\theta$, as measured with regard to an axis normal to the surface of the specimen, the electron beam does not hit the specimen along the optical axis of the objective lens 10. The electron beam 4 is displaced from the optical axis by a distance d. Therefore, the stage 11 performs a corresponding movement with the specimen 8 so that the electron beam hits the same area on the specimen that would have been hit, if the electron beam had not been deflected by the beam shift coils 7A. When the deflection of the electron beam 4 and, accordingly, the angle of incidence $\theta$ is changed, for example to -$\theta$, the stage 11 again moves the specimen 8 to a new position so that any misregistration between the two images can basically be avoided.

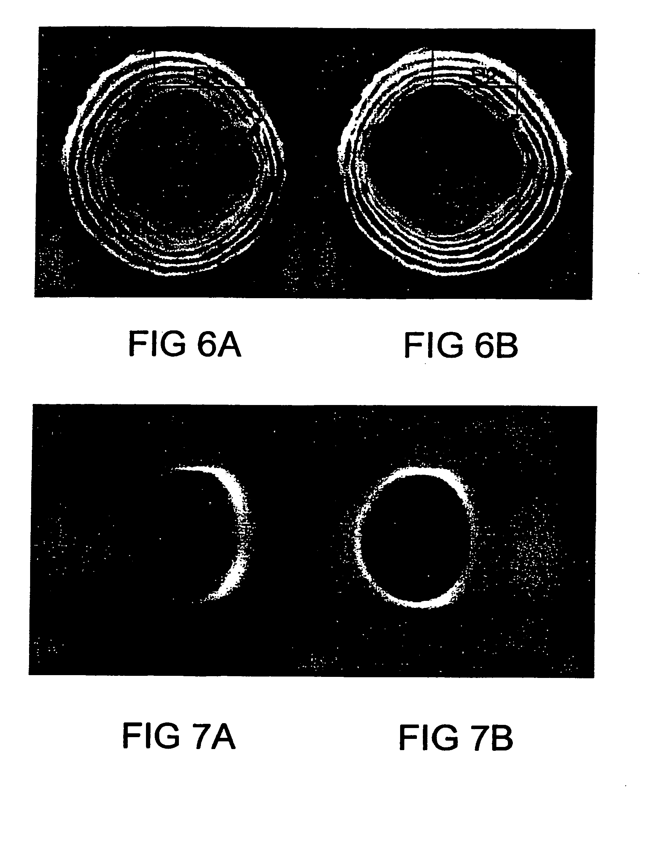

Fig. 6A and Fig. 6B together with following description will explain how according to the present invention an accurate height measurement is performed. Fig. 6A and Fig. 6B show a pillar which extends from a flat surface. Fig. 6A is an image of the pillar taken with a beam tilt of $\theta_L$ = - 3° whereas Fig. 6B is an image of the pillar taken with a beam tilt of $\theta_R$ = + 3° with respect to an axis normal to the flat surface.

To determine the height difference Δh between the top of the pillar and the bottom surface a distinctive feature has to be located for each level. On top of the pillar the right end of a flake was used as the first distinctive feature. On the bottom surface the end of a particle was used as the second distinctive feature. In both images the distance in X-direction between the two features is measured, P1 for Fig. 6A and P2 for Fig. 6B. The difference P between the distance P1 and the distance P2 (P = P1 - P2, P is called the parallax) is then used in order to calculate the height difference Δh between the top of the pillar and the bottom surface. The height difference Δl is given by the formula:

$$\Delta h = P * ((\sin\theta_R * \sin\theta_L)/(\sin\theta_R - \sin\theta_L))$$

For small angle approximation ($\theta_R$, $\theta_L \leq 5°$) the height difference can also be given by:

$$\Delta h = P/(2 * \sin((\theta_R - \theta_L)/2)).$$

In the example shown in Figures 6A and 6B the distance P1 corresponds to 0.546 $\mu$m whereas the distance P2 corresponds to 0.433 $\mu$m. Accordingly, the height difference Ah between the top of the pillar and the bottom surface in this example is 1.079 $\mu$m.

Due to the present invention it does not take any extra effort to gain additional height information from the specimen. However, this additional information is often extremely valuable, particularly on specimens whose topography is complex. In this example the height of a pillar was determined. It is clear, however, that the same procedure can also be used to determine the depth of a trench or a hole. In case of a semiconductor wafer the accurate depth of a trench, for example the depth of an isolation trench, or the accurate depth of a contact hole is extremely useful information in order to control the quality of the production process.

Once the depth of a trench or a hole or the height of a line is known, this information can be used in order to determine further interesting features. For example, by knowing the depth of a contact hole, a further embodiment of the present invention can be used, in order to determine the true width of the contact hole at its bottom. Fig. 7A and Fig. 7B show a contact hole extending downward from a flat surface. Fig. 7A is an image of the contact hole taken with a beam tilt of $\theta_L$ = - 3° whereas Fig. 7B is an image of the contact hole taken with a beam tilt of $\theta_R$ = + 3° with respect to an axis normal to the flat surface.

In Fig. 7A (left view) the left top edge $T_1$, the right top edge $T_2$ and the right bottom edge $B_L$ of the contact hole can be seen. In Fig. 7B (right view) again the left top edge $T_1$ and the right top edge $T_2$ can be seen. Furthermore, the left bottom edge $B_R$ of the contact hole is visible. By measuring the visible distances $T_1B_L$ and $T_1T_2$ as measured in Fig. 7A , the left view, and the distance $T_2B_R$ as measured in Fig. 7B, the right view, the true width $W_b$ of the contact hole at its bottom can be calculated:

$$W_b = T_1B_L/\cos\theta_L + T_2B_R/\cos\theta_R + h(\tan\theta_L + \tan\theta_R) - W_t$$

where h is the depth of the contact hole and $W_t$ is the width of the contact hole at the top. In the present example $W_t$ is given by $T_1T_2/\cos\theta_L$. In the example shown in Figures 7A and 7B the distance $T_1B_L/\cos\theta_L$ corresponds to 0.29 $\mu$m, the distance $T_2B_R/\cos\theta_R$ corresponds to 0.334 $\mu$m and the distance $T_1T_2/\cos\theta_L$ corresponds to 0.4005 $\mu$m. Furthermore, the depth h of the contact hole was determined to be 1.0 $\mu$m. Accordingly, the true width $W_b$ of the contact hole at its bottom in this example is 0.324 $\mu$m.

The method has the advantage that true width W of the contact hole at its bottom can be determined even for contact holes having high aspect ratio (deep and narrow). This is in contrast to other methods, like the atomic force microscopy, which exhibit extreme difficulties in these cases.

In addition to the determination of the true width W of the contact hole at its bottom, a further embodiment of the present invention can be used, in order to determine the width of a sidewall which is visible in the figures 7A or 7B. For example, from Fig. 7B the width of the left sidewall of the contact hole can be determined. The width of the sidewall in this context means the lateral distance in horizontal wafer plane direction between the top of the sidewall and the bottom of the sidewall. By measuring the visible distance $T_2B_R$ as measured in Fig. 7B the true width $W_L$ of the left sidewall of the contact hole can be calculated:

$$W_L = W_t - T_2B_R/\cos\theta_R - h\tan\theta_R$$

where $T_2B_R$ is the visible distance as measured between the bottom edge of the sidewall and the top edge on the opposite side of the trench or hole, h is the depth of the trench or hole, $W_t$ is the width of the trench or hole at the top of the trench or the hole, and $\theta_R$ is the viewing angle of the image of Fig. 7B.

Similarly, by measuring the visible distance $T_1B_L$ as measured in Fig. 7A the true width $W_R$ of the left sidewall of the contact hole can be calculated:

$$W_R = W_t - T_1B_L/\cos\theta_L - h\tan\theta_L$$

where $T_1B_L$ is the visible distance as measured between the bottom edge of the sidewall and the top edge on the opposite side of the trench or hole, h is the depth of the trench or hole, $W_t$ is the width of the trench or hole at the top of the trench or the hole, and $\theta_L$ is the viewing angle of the image of Fig. 7A.

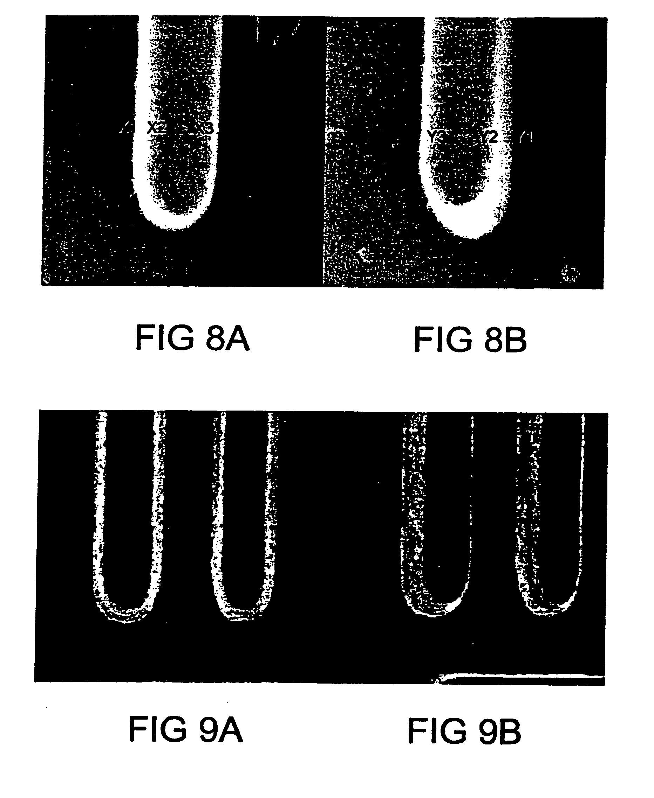

According to a further embodiment of the present invention, by knowing the height of a line a pair of stereo images of that line can be used in order to determine the true width of the line at its bottom. Fig. 8A, the left view, and Fig. 8B, the right view, show a line extending upward from a flat surface. Fig. 8A is an image of the line taken with a beam tilt of $\theta_L = -3°$ whereas Fig. 8B is an image of the line taken with a beam tilt of $\theta_R = +3°$ with respect to an axis normal to the flat surface.

In Fig. 8A the left bottom edge $X_1$, the left top edge $X_2$ and the right top edge $X_3$ of the line can be seen. In Fig. 8B again the left top edge $Y_3$ and the right top edge $Y_2$ can be seen. Furthermore, the right bottom edge $Y_1$ of the line is visible. By measuring the visible distances $X_1X_2$ and $X_2X_3$ as measured in Fig. 8A and the visible distances $Y_1Y_2$ and $Y_2Y_3$ as measured in Fig. 8B the true width $W_b$ of the line at its bottom can be calculated:

$$W_b = (X_1X_2+X_2X_3)/\cos\theta_L + (Y_1Y_2+Y_2Y_3)/\cos\theta_R - h(\tan\theta_L + \tan\theta_R) - W_t$$

or

$$(X_1X_2+X_2X_3 = X_1X_3 \, , \, Y_1Y_2+Y_2Y_3 = Y_1Y_3)$$

or

$$W_b = X_1X_3/\cos\theta_L + Y_1Y_3/\cos\theta_R - h(\tan\theta_L + \tan\theta_R) - W_t$$

where h is the height of the line and $W_t$ is the width of the feature at the top of the feature. For example, $W_t$ is given by $Y_2Y_3/\cos\theta_R$.. In the example shown in Figures 8A and 8B the distance $(X_1X_2 + X_2X_3)/\cos\theta_L$ corresponds to 0.274 $\mu$m, the distance $(Y_1Y_2 + Y_2Y_3)/\cos\theta_R$ corresponds to 0.312 $\mu$m and the distance $Y_2Y_3/\cos\theta_R$ corresponds to 0.232 $\mu$m. Furthermore, the depth h of the line was determined to be 0.8 $\mu$m. Accordingly, the true width $W_b$ of the line at its bottom in this example is 0.27 $\mu$m.

Instead of the above presented formula, further equivalent formula can also be used, for example:

$$W_b = X_1X_2/\cos\theta_L + (Y_1Y_2+Y_2Y_3)/\cos\theta_R - h(\tan\theta_L + \tan\theta_R)$$

or

$$W_b = (X_1X_2 + X_2X_3)/\cos\theta_L + Y_1Y_2/\cos\theta_R - h(\tan\theta_L + \tan\theta_R)$$

or

$$W_b = X_1X_2/\cos\theta_L + Y_1Y_2/\cos\theta_R - h(\tan\theta_L + \tan\theta_R) + W_t.$$

Again, this method has the advantage that true width W of the line at its bottom can be determined even for lines having high aspect ratio (high and narrow). This is in contrast to other methods, like the atomic force microscopy, which exhibit extreme difficulties in these cases.

In addition to the determination of the true width W of the line at its bottom, a further embodiment of the present invention can be used, in order to determine the the width of a sidewall which is visible in the figures 8A or 8B. For example, from Fig. 8B the width of the right sidewall of the line can be determined. The width of the sidewall in this context means the lateral distance in horizontal direction between the top of the sidewall and the bottom of the sidewall. By measuring the visible distance $Y_1Y_2$ as measured in Fig. 8B the true width $W_R$ of the right sidewall of the line can be calculated:

$$W_R = Y_1Y_2/\cos\theta_R - h\tan\theta_R$$

where $Y_1Y_2$ is the visible distance as measured between the bottom edge and the top edge of the sidewall of the feature, h is the height of the feature, and $\theta_R$ is the viewing angle of the image of Fig 8B.

Similarly, by measuring the visible distance $X_1X_2$ as measured in Fig. 8A the true width $W_L$ of the left sidewall of the line can be calculated:

$$W_L = X_1X_2/\cos\theta_L - h\tan\theta_L$$

where $X_1X_2$ is the visible distance as measured between the bottom edge and the top edge of the sidewall of the feature, h is the height of the feature, and $\theta_L$ is the viewing angle of the image of Fig 8A.

Fig. 9A and Fig. 9B show a top view and a tilt view of a trench present on the surface of a wafer. As can be seen from Fig. 9B, the tilt view makes it possible to see and to define the true character of the sidewall of the trench. In the tilt view the sidewall can be seen much better and with significantly more details which are undetectable in Fig. 9A, the top view. Accordingly, a sidewall profile of the left sidewall of the trench can be compiled from Fig. 9B. Furthermore, by looking at same edge portions in both images, it is easy to see that the edge in the tilt view captures about twice as many pixels as in the top view. Obviously, this leads to a measurement of the edge width having a significantly better accuracy.

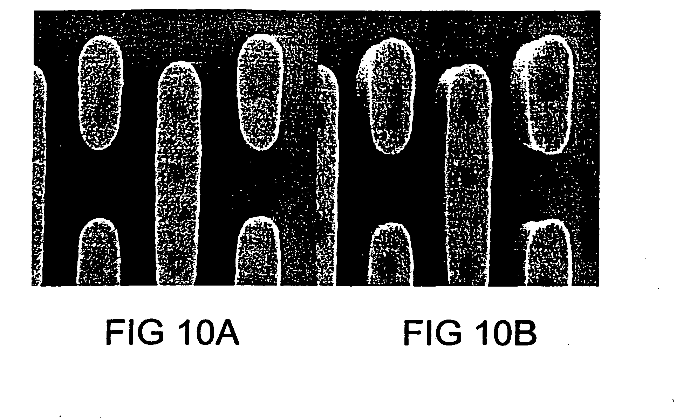

Fig. 10A and Fig. 10B show a top view and a tilt view of a line present on the surface of a wafer. Again, the tilt view (Fig. 10B) makes it possible to see and to define the true character of the sidewall of the line. In the tilt view the side wall can be defined as T-top and its profile can be determined. In the top (Fig. 10A) the T-top is undetectable.

While the invention has been described with reference to various exemplary embodiments thereof, those of ordinary skill in the art would appreciate that various implementations and variations are possible without departing from the scope of the invention, as defined by the appended claims. For example, it should be readily apparent that angles and the height and width dimension presented with regard to Figures 6 to 8 are only examples and that other angles, height and width dimension can be used. Similarly, the configuration of the objective lens is provided as example only, and other configurations of the objective lens may be used.

## Claims

1. A method for the examination of specimen with a beam of charged particles, said method comprising the steps of:

    a) scanning the beam over the specimen, to produce a first image, whereby the beam hits the surface of the specimen at a first angle of incidence;

b) tilting the beam and moving the specimen to a position corresponding to the tilting of the beam so that the beam hits the surface of the specimen at a second angle of incidence and that the displacement of the beam caused by the tilting of the beam is basically compensated,

wherein the tilting of the beam is achieved by the combined action of deflecting the beam away from the optical axis of an objective and focusing the beam onto the specimen; and

c) scanning the beam over the specimen, to produce a second image, whereby the beam hits the surface of the specimen under the second angle of incidence,

**characterized in that** the deflection of the beam is done inside the field of the objective or **in that** the beam is deflected in two steps, the first step being done before the beam enters the field of the objective and the second step being done inside the field of the objective.

2. The method according one of claim 1 wherein the beam is deflected in two steps which are adjusted to each other so that the chromatic aberrations on the surface of the specimen are minimized.

3. The method according to one of the preceding claims wherein the two images are used to measure height differences on the specimen.

4. The method according to one of claims 1 to 2 wherein the two images are used to measure the width of a feature recessed in the surface of a specimen, such as a trench or a hole, at the bottom of the feature.

5. The method according to one of claims 1 to 2 wherein the two images are used to measure the width of a feature protruding from the surface of the specimen at the bottom of the feature.

6. The method according to one of claims 1 to 2 wherein the two images are used to compile a stereoscopic image of the surface of the specimen that can be used to produce a 3-dimensional perception.

7. The method according to one of claims 1 to 2 wherein the two images are used to produce a 3-dimensional representation of a feature.

8. The method according to one of claims 1 to 2 wherein the two images are used to measure the width of an edge of a feature.

9. The method according to one of claims 1 to 2 wherein the two images are used to compile a sidewall profile of a feature.

10. The method according to one of the preceding claims wherein a reference target is provided in order to determine the precise angle of incidence.

11. A charged particle apparatus for the examination of specimen comprising:

a) a particle source for providing a beam of charged particles;

b) an objective for focusing the charged particle beam onto the specimen;

c) a detector for measuring at least one secondary product and/or backscattered particles coming from the specimen;

d) at least one deflector for deflecting the beam away from the optical axis of the objective so that by the combined action of the deflector and the objective the beam is tilted and hits the specimen with a predetermined angle of incidence;

e) a specimen support for bringing the specimen to position corresponding to the tilt of the beam; and

f) a scanning unit for scanning the charged particle beam over the specimen, so that an image is generated;

**characterized in that** the deflector is located within the field of the objective.

12. The apparatus according to claim 11 wherein the apparatus comprises two deflectors which are adjusted to each other so that the chromatic aberrations on the surface of the specimen are minimized.

13. The apparatus according to claim 12 wherein the first deflector is located before the objective outside the field of the objective and the second deflector is the deflector located within the field of the objective.

14. The apparatus according to one of claims 11 to 13 wherein the objective is a combination of a magnetic lens and an electrostatic lens.

15. The apparatus according to claim 14 wherein an electrostatic retarding field is provided between the electrostatic lens and the specimen.

16. The apparatus according to one of claims 11 to 15 wherein a reference target is provided in order to determine the precise angle of incidence.

17. The method according to any of claims 1 to 10, the method further comprising the steps of:

providing a beam of charged particles;
deflecting the beam away from the optical axis of an objective, said deflection is done in at least two steps which are adjusted to each other so that the chromatic aberrations on the surface of the specimen are minimized; and
focusing the beam onto the surface of the specimen, so that the beam hits the surface of the specimen under the predetermined angle of incidence.

18. The method according to claim 17 wherein the first step is done before the beam enters the field of the objective and the second step is done inside the field of the objective.

19. The method according to one of claims 17 or 18 wherein the focusing of the beam is done by a combination of a magnetic lens and an electrostatic lens.

20. The method according to claim 19 wherein an electrostatic retarding field is provided between the electrostatic lens and the specimen.

21. The apparatus according to any of claims 11 to 16, comprising
at least two deflectors for deflecting the beam away from the optical axis of the objective so that by the combined action of the deflectors and the objective the beam is tilted and hits the specimen with a predetermined angle of incidence, said deflectors being adjusted to each other so that the chromatic aberrations on the surface of the specimen are minimized.

22. The apparatus according to claim 21 wherein a first deflector is located before the objective outside the field of the objective and a second deflector is located within the field of the objective.

23. The apparatus according to one of claims 21 or 22 wherein the objective is a combination of a magnetic lens and an electrostatic lens.

24. The apparatus according to claim 23 wherein an electrostatic retarding field is provided between the electrostatic lens and the specimen.

**Patentansprüche**

1. Verfahren zur Untersuchung eines Spezimens mit einem Strahl geladener Teilchen, wobei das Verfahren die folgenden Schritte umfasst:

(a) Abtasten des Spezimens mit dem Strahl, um ein erstes Bild herzustellen, wobei der Strahl in einem ersten Einfallswinkel auf die Oberfläche des Spezimens auftrifft;
(b) Schrägstellen des Strahls und Bewegen des Spezimens zu einer Position, die der Schrägstellung des Strahls entspricht, so dass der Strahl in einem zweiten Einfallswinkel auf die Oberfläche des Spezimens auftrifft, und dass die durch die Schrägstellung des Stahls bewirkte Ortsveränderung des Strahls im Wesentlichen ausgeglichen wird,
wobei die Schrägstellung des Strahls durch die kombinierte Aktion des Ablenkens des Strahls weg von der optischen Achse eines Objektivs und des Fokussierens des Strahls auf das Spezimen erzielt wird; und
(c) Abtasten des Spezimens mit dem Strahl, um ein zweites Bild herzustellen, wobei der Strahl unter dem zweiten Einfallswinkel auf die Oberfläche des Spezimens auftrifft,
**dadurch gekennzeichnet, dass** die Ablenkung des Strahls innerhalb des Felds des Objektivs erfolgt oder der Strahl in zwei Schritten abgelenkt wird, wobei der erste Schritt erfolgt, bevor der Strahl in das Feld des Objektivs eintritt, und der zweite Schritt innerhalb des Felds des Objektivs erfolgt.

2. Verfahren nach Anspruch 1, wobei der Strahl in zwei Schritten abgelenkt wird, die so aufeinander abgestimmt sind, dass die chromatischen Aberrationen an der Oberfläche des Spezimens minimiert sind.

3. Verfahren nach einem der vorhergehenden Ansprüche, wobei die zwei Bilder dazu verwendet werden, Höhendifferenzen am Spezimen zu messen.

4. Verfahren nach einem der Ansprüche 1 bis 2, wobei die zwei Bilder dazu verwendet werden, die Breite eines in die Oberfläche eines Spezimens eingelassenen Merkmals wie etwa eines Grabens oder Lochs am Grund des Merkmals zu messen.

5. Verfahren nach einem der Ansprüche 1 bis 2, wobei die zwei Bilder dazu verwendet werden, die Breite eines von der Oberfläche des Spezimens vorstehenden Merkmals am Grund des Merkmals zu messen.

6. Verfahren nach einem der Ansprüche 1 bis 2, wobei die zwei Bilder dazu verwendet werden, eine stereoskopisches Bild der Oberfläche des Spezimens zu erstellen, das dazu verwendet werden kann, eine 3-dimensionale Wahrnehmung zu erzeugen.

7. Verfahren nach einem der Ansprüche 1 bis 2, wobei die zwei Bilder dazu verwendet werden, eine 3-dimensionale Darstellung eines Merkmals herzustellen.

8. Verfahren nach einem der Ansprüche 1 bis 2, wobei die zwei Bilder dazu verwendet werden, die Breite eines Rands eines Merkmals zu messen.

9. Verfahren nach einem der Ansprüche 1 bis 2, wobei die zwei Bilder dazu verwendet werden, ein Seitenwandprofil eines Merkmals zu erstellen.

10. Verfahren nach einem der vorhergehenden Ansprüche, wobei ein Referenzziel bereitgestellt wird, um den genauen Einfallswinkel zu bestimmen.

11. Ladungspartikelvorrichtung zur Spezimenuntersuchung, Folgendes aufweisend:

a) eine Teilchenquelle zum Bereitstellen eines Strahls geladener Teilchen;
b) ein Objektiv zum Fokussieren des Strahls geladener Teilchen auf das Spezimen;
c) einen Detektor zum Messen mindestens eines Sekundärprodukts und/oder rückgestreuter Teilchen, die vom Spezimen kommen;
d) mindestens einen Deflektor zum Ablenken des Strahls weg von der optischen Achse des Objektivs, so dass durch die kombinierte Aktion des Deflektors und des Objektivs der Strahl schräggestellt wird und mit einem vorbestimmten Einfallswinkel auf das Spezimen auftrifft;
e) eine Spezimenhalterung, um das Spezimen zu einer der Schrägstellung des Strahls entsprechenden Position zu bringen; und
f) eine Abtasteinheit zum Abtasten des Spezimens mit dem Strahl geladener Teilchen, so dass ein Bild entsteht; **dadurch gekennzeichnet, dass** sich der Deflektor innerhalb des Felds des Objektivs befindet.

12. Vorrichtung nach Anspruch 11, wobei die Vorrichtung zwei Deflektoren umfasst, die so aufeinander abgestimmt sind, dass die chromatischen Aberrationen an der Oberfläche des Spezimens minimiert sind.

13. Vorrichtung nach Anspruch 12, wobei sich der erste Deflektor vor dem Objektiv außerhalb des Felds des Objektivs befindet und sich der zweite Deflektor innerhalb des Felds des Objektivs befindet.

14. Vorrichtung nach einem der Ansprüche 11 bis 13, wobei es sich bei dem Objektiv um eine Kombination einer magnetischen Linse und einer elektrostatischen Linse handelt.

15. Vorrichtung nach Anspruch 14, wobei ein elektrostatisches Verzögerungsfeld zwischen der elektrostatischen Linse und dem Spezimen vorgesehen ist.

16. Vorrichtung nach einem der Ansprüche 11 bis 15, wobei ein Referenzziel vorgesehen ist, um den genauen Einfalls-

**EP 1 238 405 B1**

winkel zu bestimmen.

17. Verfahren nach einem der Ansprüche 1 bis 10, darüber hinaus die folgenden Schritte umfassend:

Bereitstellen eines Strahls geladener Teilchen;
Ablenken des Strahls weg von der optischen Achse des Objektivs, wobei die Ablenkung in mindestens zwei Schritten erfolgt, die so aufeinander abgestimmt sind, dass die chromatischen Aberrationen an der Oberfläche des Spezimens minimiert sind; und
Fokussieren des Strahls auf die Oberfläche des Spezimens so, dass der Strahl unter dem vorbestimmten Einfallswinkel auf die Oberfläche des Spezimens auftrifft.

18. Verfahren nach Anspruch 17, wobei der erste Schritt erfolgt, bevor der Strahl in das Feld des Objektivs eintritt, und der zweite Schritt innerhalb des Felds des Objektivs erfolgt.

19. Verfahren nach einem der Ansprüche 17 oder 18, wobei das Fokussieren des Strahls durch eine Kombination aus einer magnetischen Linse und einer elektrostatischen Linse erfolgt.

20. Verfahren nach Anspruch 19, wobei ein elektrostatisches Verzögerungsfeld zwischen der elektrostatischen Linse und dem Spezimen vorgesehen ist.

21. Vorrichtung nach einem der Ansprüche 11 bis 16, Folgendes aufweisend
mindestens zwei Deflektoren, um den Strahl weg von der optischen Achse des Objektivs so abzulenken, dass der Strahl durch die kombinierte Aktion der Deflektoren und des Objektivs schräggestellt wird und mit einem vorbestimmten Einfallswinkel auf das Spezimen auftrifft, wobei die Deflektoren so aufeinander abgestimmt sind, dass die chromatischen Aberrationen an der Oberfläche des Spezimens minimiert sind.

22. Vorrichtung nach Anspruch 21, wobei sich ein erster Deflektor vor dem Objektiv außerhalb des Felds des Objektivs befindet, und sich ein zweiter Deflektor innerhalb des Felds des Objektivs befindet.

23. Vorrichtung nach einem der Ansprüche 21 oder 22, wobei es sich bei dem Objektiv um eine Kombination aus einer magnetischen Linse und einer elektrostatischen Linse handelt.

24. Vorrichtung nach Anspruch 23, wobei ein elektrostatisches Verzögerungsfeld zwischen der elektrostatischen Linse und dem Spezimen vorgesehen ist.

**Revendications**

1. Procédé destiné à l'examen d'un échantillon avec un faisceau de particules chargées, ledit procédé comprenant les étapes consistant à :

a) balayer le faisceau sur l'échantillon pour produire une première image, le faisceau frappant la surface de l'échantillon selon un premier angle d'incidence ;
b) incliner le faisceau et déplacer l'échantillon dans une position correspondant à l'inclinaison du faisceau de sorte que le faisceau frappe la surface de l'échantillon selon un deuxième angle d'incidence et que le déplacement du faisceau provoqué par l'inclinaison du faisceau soit fondamentalement compensé,
sachant que l'inclinaison du faisceau est obtenue par l'action combinée de déviation du faisceau par rapport à l'axe optique d'un objectif et de focalisation du faisceau sur l'échantillon ; et
c) balayer le faisceau sur l'échantillon pour produire une deuxième image, le faisceau frappant la surface de l'échantillon selon le deuxième angle d'incidence,
**caractérisé en ce que** la déviation du faisceau est effectuée à l'intérieur du champ de l'objectif ou **en ce que** le faisceau est dévié en deux étapes, la première étape étant effectuée avant que le faisceau entre dans le champ de l'objectif et la deuxième étape étant effectuée à l'intérieur du champ de l'objectif.

2. Le procédé selon la revendication 1, dans lequel le faisceau est dévié en deux étapes qui sont ajustées l'une par rapport à l'autre de façon que les aberrations chromatiques sur la surface de l'échantillon soient minimisées.

3. Le procédé selon l'une des revendications précédentes, dans lequel les deux images sont utilisées pour mesurer des différences de hauteur sur l'échantillon.

4. Le procédé selon l'une des revendications 1 à 2, dans lequel les deux images sont utilisées pour mesurer la largeur d'un attribut logé dans la surface d'un échantillon, tel qu'une tranchée ou un trou, au fond de l'attribut.

5. Le procédé selon l'une des revendications 1 à 2, dans lequel les deux images sont utilisées pour mesurer la largeur d'un attribut saillant par rapport à la surface de l'échantillon au fond de l'attribut.

6. Le procédé selon l'une des revendications 1 à 2, dans lequel les deux images sont utilisées pour compiler une image stéréoscopique de la surface de l'échantillon qui peut être utilisée pour produire une perception tridimensionnelle.

7. Le procédé selon l'une des revendications 1 à 2, dans lequel les deux images sont utilisées pour produire une représentation tridimensionnelle d'un attribut.

8. Le procédé selon l'une des revendications 1 à 2, dans lequel les deux images sont utilisées pour mesurer la largeur d'un bord d'un attribut.

9. Le procédé selon l'une des revendications 1 à 2, dans lequel les deux images sont utilisées pour compiler un profil de paroi latérale d'un attribut.

10. Le procédé selon l'une des revendications précédentes, dans lequel une cible de référence est fournie afin de déterminer l'angle d'incidence précis.

11. Dispositif à particules chargées pour l'examen d'un échantillon, comprenant :

a) une source de particules destinée à fournir un faisceau de particules chargées ;
b) un objectif destiné à focaliser le faisceau de particules chargées sur l'échantillon ;
c) un détecteur destiné à mesurer au moins un produit secondaire et/ou des particules rétrodiffusées depuis l'échantillon ;
d) au moins un déviateur destiné à dévier le faisceau par rapport à l'axe optique de l'objectif de sorte que, par l'action combinée du déviateur et de l'objectif, le faisceau soit incliné et frappe l'échantillon avec un angle d'incidence prédéterminé ;
e) un support d'échantillon destiné à mettre l'échantillon dans une position correspondant à l'inclinaison du faisceau ; et
f) une unité de balayage destinée à balayer le faisceau de particules chargées sur l'échantillon de sorte qu'une image soit générée ;
**caractérisé en ce que** le déviateur est situé à l'intérieur du champ de l'objectif.

12. Le dispositif selon la revendication 11, dans lequel le dispositif comprend deux déviateurs qui sont ajustés l'un par rapport à l'autre de façon que les aberrations chromatiques sur la surface de l'échantillon soient minimisées.

13. Le dispositif selon la revendication 12, dans lequel le premier déviateur est situé devant l'objectif à l'extérieur du champ de l'objectif et le deuxième déviateur est le déviateur situé à l'intérieur du champ de l'objectif.

14. Le dispositif selon l'une des revendications 11 à 13, dans lequel l'objectif est une combinaison d'une lentille magnétique et d'une lentille électrostatique.

15. Le dispositif selon la revendication 14, dans lequel un champ retardateur électrostatique est prévu entre la lentille électrostatique et l'échantillon.

16. Le dispositif selon l'une des revendications 11 à 15, dans lequel une cible de référence est fournie afin de déterminer l'angle d'incidence précis.

17. Le procédé selon l'une quelconque des revendications 1 à 10, le procédé comprenant en outre les étapes consistant à :

fournir un faisceau de particules chargées ;

dévier le faisceau par rapport à l'axe optique d'un objectif, ladite déviation étant effectuée en au moins deux étapes qui sont ajustées l'une par rapport à l'autre de façon que les aberrations chromatiques sur la surface de l'échantillon soient minimisées ; et

focaliser le faisceau sur la surface de l'échantillon, de sorte que le faisceau frappe la surface de l'échantillon selon l'angle d'incidence prédéterminé.

18. Le procédé selon la revendication 17, dans lequel la première étape est effectuée avant que le faisceau entre dans le champ de l'objectif et la deuxième étape est effectuée à l'intérieur du champ de l'objectif.

19. Le procédé selon l'une des revendications 17 ou 18, dans lequel la focalisation du faisceau est effectuée par une combinaison d'une lentille magnétique et d'une lentille électrostatique.

20. Le procédé selon la revendication 19, dans lequel le champ retardateur électrostatique est fourni entre la lentille électrostatique et l'échantillon.

21. Le dispositif selon l'une quelconque des revendications 11 à 16, comprenant
au moins deux déviateurs destinés à dévier le faisceau par rapport à l'axe optique de l'objectif de sorte que, par l'action combinée des déviateurs et de l'objectif, le faisceau soit incliné et frappe l'échantillon avec un angle d'incidence prédéterminé, lesdits déviateurs étant ajustés l'un par rapport à l'autre de façon que les aberrations chromatiques sur la surface de l'échantillon soient minimisées.

22. Le dispositif selon la revendication 21, dans lequel un premier déviateur est situé devant l'objectif à l'extérieur du champ de l'objectif et un deuxième déviateur est situé à l'intérieur du champ de l'objectif.

23. Le dispositif selon l'une des revendications 21 ou 22, dans lequel l'objectif est une combinaison d'une lentille magnétique et d'une lentille électrostatique.

24. Le dispositif selon la revendication 23, dans lequel un champ retardateur électrostatique est prévu entre la lentille électrostatique et l'échantillon.

FIG 1

FIG 2

FIG 3

14

10A

7B

10B

FIG 4

8

14

10A

7B

10B

FIG 5

8

d

FIG 6A          FIG 6B

FIG 7A          FIG 7B

FIG 8A     FIG 8B

FIG 9A     FIG 9B

EP 1 238 405 B1

FIG 10A          FIG 10B

22

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 58137949 A

### Non-patent literature cited in the description

- **B.C. BRENTON et al.** A DYNAMIC REAL TIME 3-D MEASUREMENT TECHNIQUE FOR IC INSPECTION. *Microelectronic Engineering,* 1986, vol. 5, 541-545
- **NORTH HOLLAND ; J.T.L. THONG et al.** In Situ Topography Measurement in the SEM. *SCANNING,* 1992, vol. 14, 65-72
- Local High Mag Scanning at Two Tail Ends of Low Mag Scanning For Creating High Mag Stereo Images. *IBM Technical Disclosere Bulletin,* 1991, vol. 34 (4B